# EUROPEAN PATENT SPECIFICATION

(11) **EP 2 259 377 B1**
(45) Date of publication and mention of the grant of the patent: **03.06.2020**
(21) Application number: 09722439.8
(22) Date of filing: 17.03.2009
(51) Int. Cl.: H01G 9/20

(54) **SOLAR CELL**
SOLARZELLE
CELULLE SOLAIRE

(30) Priority: 19.03.2008 JP 2008071265
(43) Date of publication of application: 08.12.2010
(73) Proprietor: Sharp Kabushiki Kaisha, Osaka-shi, Osaka 545-8522 (JP)
(72) Inventor: HAN, Liyuan, Abeno-ku, Osaka-shi, Osaka 545-8522 (JP); FUKE, Nobuhiro, Abeno-ku, Osaka-shi, Osaka 545-8522 (JP); KOIDE, Naoki, Abeno-ku, Osaka-shi, Osaka 545-8522 (JP); ISLAM, Ashraful, Abeno-ku, Osaka-shi, Osaka 545-8522 (JP); FUKUI, Atsushi, Abeno-ku, Osaka-shi, Osaka 545-8522 (JP)
(74) Representative: Müller Hoffmann & Partner
(86) International application number: PCT/JP2009/055121
(87) International publication number: WO 2009/116511

(56) References cited:
- JP-A- 2003 086 257
- JP-A- 2004 087 148
- JP-A- 2005 129 259
- JP-A- 2006 024 495
- JP-A- 2006 139 961
- JP-A- 2006 310 186
- JP-A- 2007 103 310
- JP-A- 2007 234 580
- MORA-SERO I ET AL: "Large improvement of electron extraction from CdSe quantum dots into a TiO"2 thin layer by N3 dye coabsorption", THIN SOLID FILMS, ELSEVIER, AMSTERDAM, NL, vol. 516, no. 20, 23 December 2007 (2007-12-23), pages 6994-6998, XP022777897, ISSN: 0040-6090, DOI: 10.1016/J.TSF.2007.12.110 [retrieved on 2007-12-23]
- DÜRR M ET AL: "On the origin of increased open circuit voltage of dye-sensitized solar cells using 4-tert-butyl pyridine as additive to the electrolyte", APPLIED PHYSICS LETTERS, A I P PUBLISHING LLC, US, vol. 89, no. 6, 9 August 2006 (2006-08-09) , pages 61110-061110, XP012088338, ISSN: 0003-6951, DOI: 10.1063/1.2266386
- VOGEL R ET AL: "QUANTUM-SIZED PBS, CDS, AG2S, AND BI2S3 PARTICLES AS SENSITIZERS FOR VARIOUS NANOPOROUS WIDE-BANDGAP SEMICONDUCTORS", JOURNAL OF PHYSICAL CHEMISTRY, AMERICAN CHEMICAL SOCIETY, US, vol. 98, no. 12, 1 January 1994 (1994-01-01), pages 3183-3188, XP000956096, ISSN: 0022-3654, DOI: 10.1021/J100063A022
- HOTCHANDANI S ET AL: "INTERACTION OF SEMICONDUCTOR COLLOIDS WITH J-AGGREGATES OF A SQUARAINE DYE AND ITS ROLE IN SENSITIZING NANOCRYSTALLINE SEMICONDUCTOR FILMS", RESEARCH ON CHEMICAL INTERMEDIATES : AN INTERNAT. JOU, AMSTERDAM, NL, vol. 20, no. 9, 1 January 1994 (1994-01-01), pages 927-938, XP008032982, ISSN: 0922-6168

## Description

### TECHNICAL FIELD

The present invention relates to a photosensitizer and a solar cell using the photosensitizer and, more specifically, to a photosensitizer with improved incident photon-to-current conversion efficiency and a solar cell using the same.

### BACKGROUND ART

Recently, as an energy source alternative to fossil fuel, solar cells that can convert optical energy of sunlight to electric energy are attracting attention, and solar cells using crystalline silicon substrate or thin film silicon have come to be practically used. Manufacturing cost of a crystalline silicon substrate or thin film silicon, however, is very high and hence, solar cells using these inevitably become very expensive. In solar cells as such, in order to recover the cost on manufacturing, efforts have been made to reduce the cost per power output by improving the incident photon-to-current conversion efficiency. At present, however, sufficiently high incident photon-to-current conversion efficiency has not been attained.

Therefore, as a new type solar cell, a wet solar cell applying photo-induced electron transfer of a photosensitizer formed of metal complex or photosensitive dye has been proposed (for example, see Patent Document 1). A wet solar cell using the photosensitizer includes: a semiconductor electrode including a transparent substrate with an electrode formed on its surface and a semiconductor layer as a photo-electric converting material formed on the substrate; a counter electrode formed of a substrate having an electrode formed on its surface; and a carrier transport layer held therebetween, including redox species. The semiconductor layer carries, on its surface, a photosensitizer having absorption spectrum in a visible light range.

When the wet solar cell as such is irradiated with sunlight, the photosensitizer on the surface of semiconductor layer absorbs light, whereby electrons in the photosensitizer are excited. The excited electrons move to the semiconductor layer, and thereafter further move from the electrode of the semiconductor electrode through an electric circuit (not shown) to the electrode of the counter electrode, and the moved electrons reduce the redox species in the carrier transport layer. The reduced redox species causes the electrons to move to the semiconductor layer, whereby the oxidized photosensitizer is reduced. By repeating such a process, electric energy continuously converted from optical energy through the flow of electrons can be obtained.

A photosensitizer formed of photosensitizing dye, photochromic molecules, a wide gap semiconductor or the like can be used for an optical sensor, a solar cell, a photocatalyst and the like. Therefore, with increasing interest in energy conservation and environment protection, it attracts high attention. Among such photosensitizers, photosensitizing dyes used particularly for photography have long history of research and development, and dyes of high performance including cyanine dye, merocyanine dye, squarylium acid dye and phthalocyanine dye have been developed. When a photosensitive dye is used as the photosensitizer, high incident photon-to-current conversion efficiency can be attained, as the charge exchange reaction rate between the photosensitive dye and the redox species is high.

Further, a photosensitizer referred to as quantum dot has been developed (for example, see Non-Patent Documents 1, 2 and 3) in which nano clusters of inorganic material and having the size of few tens of A (angstrom) are formed and energy gap is controlled based on the size of nano clusters, whereby light absorption wavelength can be controlled. Solar cells using such quantum dots as the photosensitizer have also been proposed (see Patent Documents 2 and 3, Non-Patent Documents 4 and 5). Patent Document 2 discloses a solar cell using quantum dots of antimony sulfide (Sb2S3), and Patent Document 3 discloses a solar cell using as the photosensitizer a photocatalyst having a catalyst and semiconductor quantum dots chemically combined.

Non-Patent Document 6 describes the improvement of electron extraction from CdSe quantum dots into a TiO2 thin layer by N3 dye coabsorption.

Non-Patent Document 7 describes that a reduced interface defect density and a resulting reduction of charge carrier recombination were found to be the main mechanism for an increased open circuit voltage of dye-sensitized solar cells with 4-tert-butyl pyridine in the electrolyte. The reduction of interface defect states was traced back to specific binding of 4-tert-butyl pyridine at defect sites on the TiO2 surface.

Non-Patent Document 8 describes that the sensitization of nanoporous titanium dioxide, zinc oxide, tin dioxide, niobium oxide, and tantalum oxide by quantum-sized cadmium sulfide, lead sulfide, silver sulfide, antimony sulfide, and bismuth sulfide. It was shown that the relative positions of the energetic levels at the interface between the quantum size particles and the oxide substrate can be optimized for an efficient charge separation by utilizing the size quantization effect and by varying the materials of the particles and the substrate.

Non-Patent Document 9 describes that the dye in its aggregate form readily interacts with the TiO₂ colloids giving rise to a new charge transfer band in the red region. The apparent association constant for the dye aggregate and TiO₂ colloid as determined from a Benesi-Hildebrand plot is 1600 M⁻¹. Nanocrystalline semiconductor films prepared from TiO₂, ZnO, and SnO₂ colloids have been modified with Sq to probe the photosensitization effects. Both dye monomers and aggregates were found to participate in the charge injection process. An incident photon-to-photocurrent efficiency up to 0.7% has been observed.

Non-Patent Document 1: R. D. Shaller et. al., Physical Review Letters, (US), American Physical Society, 2004, Vol. 92, p.186601
Non-Patent Document 2: R. D. Shaller et. al., Nature Physics, 1, 2005, pp. 189-194
Non-Patent Document 3: A. Boulesbaa et. al., Journal of the American Chemical Society, (US), American Chemical Society, 2007, Vol. 129, pp. 15132-15133
Non-Patent Document 4: P. Yu et. al., The Journal of Physical Chemistry B, (US), American Chemical Society, 2006, Vol. 110, pp. 25451-25454
Non-Patent Document 5: Y. Tachibana et. al., Chemistry Letters, The Chemical Society of Japan, 2007, Vol. 36, pp. 88-89
Non-Patent Document 6: Mora-Sero I. et al., "Large improvement of electron extraction from CdSe quantum dots into a Ti02 thin layer by N3 dye coabsorption", THIN SOLID FILMS, vol. 516, no. 20, (2007), pages 6994 - 6998)
Non-Patent Document 7: DURR M et al., "On the origin of increased open circuit voltage of dye-sensitized solar cells using 4-tert-butyl pyridine as additive to the electrolyte", APPLIED PHYSICS LETTERS, A I P PUBLISHING LLC, US, vol. 89, no. 6
Non-Patent Document 8: VOGEL R et al., "QUANTUM-SIZED PbS, CdS, A928, AND Bi283 PARTICLES AS SENSITIZERS FOR VARIOUS NANOPOROUS WIDE-BANDGAP SEMICONDUCTORS", JOURNAL OF PHYSICAL CHEMISTRY, AMERICAN CHEMICAL SOCIETY, US, vol. 98, no. 12
Non-Patent Document 9: HOTCHANDANI S ET AL: "INTERACTION OF SEMICONDUCTOR COLLOIDS WITH J-AGGREGATES OF A SOUARAINE DYE AND ITS ROLE IN SENSITIZING NANOCRYSTALLINE SEMICONDUCTOR FILMS", RESEARCH ON CHEMICAL INTERMEDIATES : AN INTERNAT. JOU, AMSTERDAM, NL, vol. 20, no. 9

Patent Document 1: JP 2664194 B
Patent Document 2: JP 2007-273984 A
Patent Document 3: US PG Pub 2007/0137998

### DISCLOSURE OF THE INVENTION

### PROBLEMS TO BE SOLVED BY THE INVENTION

Quantum dots used in the conventional solar cells disclosed in Patent Documents 2 and 3 and in Non-Patent Documents 4 and 5 have high light absorption coefficient and electrons in the valence band easily make transition to the conduction band and easily absorb light, whereas electrons in the conduction band easily make transition to the valence band and easily emit light. Therefore, the life of electrons that are excited (hereinafter simply referred to as "excited electrons") is undesirably short. This possibly results in shorter durability life of solar cells and optical sensors using quantum dots as the photosensitizer. Further, the charge exchange reaction rate between the quantum dots and the redox species is low, so that it is difficult to attain sufficiently high incident photon-to-current conversion efficiency.

The present invention was made to solve the above-described problems, and its object is to provide a photosensitizer attaining high incident photon-to-current conversion efficiency and having long durability life as well as to provide a solar cell using the photosensitizer.

### MEANS FOR SOLVING THE PROBLEMS

The problem is solved by the teachings of the independent claim. Further embodiments are defined in the dependent claims. The invention is defined by the appended claims. References to embodiments which do not fall under the scope of the claims are to be understood as examples useful for understanding the invention.

According to a first aspect, the present disclosure provides a photosensitizer containing inorganic material carrying organic molecules each having an aromatic ring, and molecular weight of said organic molecule is at most 500. Since the organic molecules have aromatic rings, holes in the valence band of the inorganic material tend to be more easily reduced, whereby electrons and holes are reliably separated and charge recombination can be prevented. Therefore, excited electrons in the inorganic material come to have longer life, and electron injection to the inorganic material can be done with higher efficiency from the viewpoint of energy balance. Therefore, the photosensitizer including the inorganic material carrying such organic molecules has long durability life and attains high incident photon-to-current conversion efficiency.

Preferably, the organic molecule has an interlocking group having a function of providing physical and electrical coupling to the inorganic material. The organic molecule is physically coupled with the inorganic material by means of the interlocking group, whereby it is firmly carried by the inorganic material. Further, the interlocking group provides electric coupling that facilitates movement of excited electrons between the inorganic material and the organic molecules. Therefore, electron injection from the organic molecules to the inorganic material takes place with higher efficiency.

The molecular weight of the organic molecule is at most 500. Consequently, the organic molecule comes to have the size smaller than 1 nm, and the number of organic molecules carried by one inorganic material comes to be in a desirable range. Thus, electron injection from the organic molecules to the inorganic material takes place with higher efficiency.

More preferably, the inorganic material and the organic molecule are selected such that energy level of lowest unoccupied molecular orbital of the organic molecule becomes higher than ground state energy level of conduction band of the inorganic material. As a result, transition of electrons excited in the inorganic material to the organic molecules is reduced and, therefore, the excited electrons come to have longer life.

Preferably, the inorganic material and the organic molecule are selected such that energy level of highest occupied molecular orbital of the organic molecule becomes higher than energy level at the top of the valence band of the inorganic material. Thus, electron injection from the organic molecules to the inorganic material takes place with higher efficiency, and holes in the valence band of the inorganic material come to be more easily reduced by the organic molecules. Therefore, electrons and holes are more reliably separated, and charge recombination can be prevented. Thus, the life of excited electrons in the inorganic material can be made even longer.

More preferably, the organic molecule has a basic hetero ring or an electron donating group, and an acidic hetero ring or an electron accepting group. Thus, electron injection from the organic molecules to the inorganic material takes place with higher efficiency and higher incident photon-to-current conversion efficiency can be attained.

More preferably, the inorganic material is selected from the group consisting of cadmium sulfide, cadmium selenide, lead sulfide, lead selenide, antimony sulfide, antimony selenide, indium arsenide, and indium gallium arsenide. Therefore, electron injection from the organic molecules in the excited state to the porous semiconductor layer takes place more efficiently, and hence, photo-electric conversion with higher efficiency becomes possible.

According to a second aspect, the present disclosure provides a solar cell, including: a semiconductor electrode including a first substrate having a first conductive film formed on its surface and a porous semiconductor layer formed on the first substrate; a counter electrode including a second substrate having a second conductive film formed on its surface; and a carrier transport layer including conductive material, posed between the semiconductor electrode and the counter electrode; wherein the porous semiconductor layer carries on its surface the above-described photosensitizer. Since the photosensitizer described above is included, an inexpensive solar cell having high incident photon-to-current conversion efficiency and longer durability life can be obtained.

Preferably, energy level of highest occupied molecular orbital of the organic molecule is lower than redox potential or Fermi level of the conductive material. Therefore, electron injection to the organic molecules in the oxidized state can be done with higher efficiency, and charge exchange reaction rate between the photosensitizer and the redox species can be made higher.

More preferably, the porous semiconductor layer is formed of a metal oxide semiconductor compound. Thus, highly stable and safe solar cell can be obtained.

More preferably, difference between the energy level of highest occupied molecular orbital and the energy level of lowest unoccupied molecular orbital of the organic molecule is larger than difference between ground state energy level of the conduction band and energy level at the top of the valence band of the metal oxide semiconductor compound. Thus, it is possible to prevent the light to be absorbed by the porous semiconductor layer from being absorbed by the organic molecules and, hence, photo-electric conversion with higher efficiency becomes possible.

More preferably, the metal oxide semiconductor compound is titanium oxide. Therefore, a solar cell having superior stability and safety in which the photosensitizer can be more easily sensitized, can be obtained.

### EFFECTS OF THE INVENTION

The photosensitizer in accordance with the present invention includes an inorganic material carrying organic molecules that are molecules each having an aromatic ring, and molecular weight of said organic molecule is at most 500. Since the organic molecules have aromatic rings, holes in the valence band of the inorganic material come to be more easily reduced. Thus, electrons and holes are reliably separated, and charge recombination can be prevented. As a result, life of the excited electrons in the inorganic material can be made longer, and electron injection to the inorganic material comes to be done with higher efficiency from the viewpoint of energy balance. Therefore, the photosensitizer including the inorganic material carrying such organic molecules has longer durability life and attains high incident photon-to-current conversion efficiency.

### BRIEF DESCRIPTION OF THE DRAWINGS

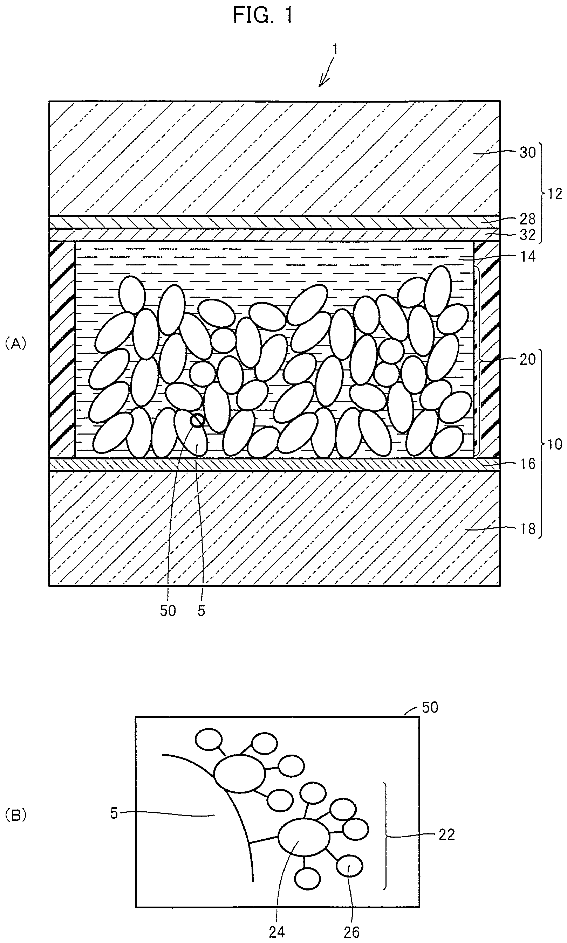

Fig. 1 includes a cross-sectional view and partially enlarged view of the solar cell in accordance with an embodiment of the present invention.

### DESCRIPTION OF THE REFERENCE SIGNS

1 solar cell, 5 semiconductor fine particles, 10 semiconductor electrode, 12 counter electrode, 14 carrier transport layer, 16, 28 conductive film, 18, 30 substrate, 20 porous semiconductor layer, 32 catalyst layer, 22 light absorber, 24 inorganic material, 26 organic molecule

### BEST MODES FOR CARRYING OUT THE INVENTION

In the following, an embodiment of the present invention will be described with reference to the figures. In the following description and in the drawings, the same components are denoted by the same reference characters and same names. Their functions are also the same. Therefore, detailed description thereof will not be repeated.

### <Configuration>

Fig. 1(A) is a cross-sectional view showing a configuration of a solar cell 1 in accordance with an embodiment of the present invention, and Fig. 1(B) is an enlarged view of a portion (a portion in a circle 50 of Fig. 1). Referring to Fig. 1, solar cell 1 includes a semiconductor electrode 10, a counter electrode 12, and a carrier transport layer 14 held therebetween. Semiconductor electrode 10 includes a substrate 18 with a conductive film 16 formed on its surface, and a porous semiconductor layer 20 formed on substrate 18. On the surface of porous semiconductor layer 20, that is, on the surface of semiconductor fine particles 5, inorganic material 24 and organic molecules 26 are held, as light absorber 22 serving as the photosensitizer. Counter electrode 12 includes a substrate 30 with a conductive film 28 formed on its surface, and a catalyst layer 32 formed on substrate 30.

In the following, semiconductor electrode 10, counter electrode 12 and carrier transport layer 14 forming solar cell 1 will be described in detail.

### [Semiconductor Electrode 10]

Semiconductor electrode 10 has substrate 18 with a conductive film 16 formed on its surface, and porous semiconductor layer 20 formed on substrate 18.

Substrate 18 is not specifically limited and any substrate that is substantially transparent and capable of supporting various portions of solar cell 1 may be used as substrate 18. A substrate of heat-resistant material such as ceramic or glass, for example, soda-lime float glass or silica glass may be used. The thickness of substrate 18 is not specifically limited as long as appropriate mechanical strength is ensured for solar cell 1 and, preferably, it is 0.5 mm to 8 mm Conductive film 16 is not specifically limited, and any film formed of transparent conductive material may be used. For example, a film of indium tin oxide (ITO), tin oxide (SnO₂), fluorine-doped tin oxide (FTO), copper iodide (CuI) or zinc oxide (ZnO) may be used. Preferable thickness of conductive film 16 is 0.02 µm to 5 µm. Conductive film 16 should preferably have low surface resistance, and surface resistance of at most 40 Ω/sq is particularly preferred. Conductive film 16 may be formed on substrate 18 by a known method such as sputtering or spraying. As to substrate 18 and conductive film 16, use of a substrate 18 formed of soda-lime float glass having conductive film 16 of FTO deposited thereon (such as a product commercially available from Nippon Sheet Glass Co., Ltd.) is preferred.

The material forming porous semiconductor layer 20 may be any photo-electric converting material generally used in the field of art, and it is not specifically limited. By way of example, metal oxide semiconductor compound such as titanium oxide (TiO₂), zinc oxide (ZnO), tin oxide (SnO₂), iron oxide (Fe₂O₃), niobium oxide (Nb₂O₅), cerium oxide (CeO₂), tungsten oxide (WO₃), barium titanate (BaTiO₃), strontium titanate (SrTiO₃), copper aluminum oxide (CuAlO₂) or strontium copper oxide (SrCu₂O₃), or a semiconductor compound such as cadmium sulfide (CdS), lead sulfide (PbS), zinc sulfide (ZnS), indium phosphide (InP) or copper-indium sulfide (CuInS₂) may be used either alone or in combination. Among these, a metal oxide semiconductor compound is preferred from the viewpoint of stability and safety, and titanium oxide is particularly preferred. Various types of narrowly defined titanium oxide including anataze-type titanium dioxide, rutile type titanium dioxide, amorphous titanium oxide, metatitanic acid or ortho titanic acid, titanium hydroxide, hydrous titanium oxide or the like may be used either alone or as a mixture. Crystalline titanium dioxide may take either of the two forms depending on method of manufacturing or history of heating, that is, anataze type and rutile type, and anataze type is more common. Since anataze type titanium dioxide has shorter wavelength at the longer-wavelength end of light absorption than the rutile type titanium dioxide, it is less susceptible to decrease of incident photon-to-current conversion efficiency caused by ultraviolet ray and, therefore, it facilitates sensitization of light absorber 22. Therefore, as regards sensitization of light absorber 22, high content of anataze type titanium dioxide is preferred and content of anataze type titanium oxide of 80% or higher is particularly preferred.

Porous semiconductor layer 20 is a porous film formed by using fine particles of the constituent material described above (hereinafter referred to as "semiconductor fine particles") 5. As to the form, semiconductor fine particles 5 may be of single or poly crystalline system. From the viewpoint of stability, easiness of crystal growth and low manufacturing cost, polycrystalline particles are preferred. Polycrystalline fine particles in the nano to micro scale are particularly preferred. Preferred average particle size of the semiconductor fine particles 5 is 10 nm to 500 nm. Here, the average particle size means volume-average particle size.

It is preferred to use, as semiconductor fine particles 5, fine particles of two or more different types having different particle sizes mixed within the above-mentioned range of average particle size. When semiconductor fine particles 5 of different particle sizes are used, it is preferred that the average particle size of semiconductor fine particles 5 of large particle size is ten times or more bigger than the average particle size of semiconductor fine particles 5 of small particle size. Specifically, preferable average particle size of semiconductor fine particles 5 of larger size is 100 nm to 500 nm and preferable average particle size of semiconductor fine particles 5 of smaller size is 5 nm to 50 nm. Semiconductor fine particles 5 of larger size scatters incident light and hence contribute to improve light capturing rate. Semiconductor fine particles 5 of smaller size increase the number of absorption points of light absorber 22 and, hence, contribute to increase the amount of absorption. When semiconductor fine particles 5 of different materials are to be mixed, it is more effective to use a material having higher absorption function as semiconductor fine particles 5 of smaller particle size. Semiconductor fine particles 5 of titanium oxide as the most preferable material may be manufactured in accordance with a known method described in various articles such as vapor phase or liquid phase method (hydrothermal synthesis or sulfuric-acid method), or by a method of high-temperature hydrolysis of a chloride (trade name: P25) developed by Degussa AG.

Porous semiconductor layer 20 carries on its surface inorganic material 24 and organic molecules 26 as light absorber 22 serving as the photosensitizer. More specifically, inorganic material 24 carrying organic molecules 26 is held on the surface of porous semiconductor layer 20.

As the constituent material of inorganic material 24, any material generally used as photo-electric converting material in the field of art may be used, and it is not specifically limited. For example, a material selected from the group consisting of cadmium sulfide (CdS), cadmium selenide (CdSe), lead sulfide (PbS), lead selenide (PbSe), antimony sulfide (Sb₂S₃), antimony selenide (SbSe), indium arsenide (InAs), indium gallium arsenide (InGaAs) and cadmium telluride (CdTe) may be used. By using such materials as the constituent material of inorganic material 24, efficiency of electron injection from organic molecules 26 to porous semiconductor layer 20 is improved and, therefore, photo-electric conversion with higher efficiency becomes possible.

Inorganic material 24 is used as quantum dots formed of the constituent material mentioned above. Preferable size of the quantum dot is 0.5 nm to 5 nm. Consequently, the range of wavelength that can be photo-electrically converted is widened to the longer wavelength side and, therefore, it becomes possible to convert visible light of wide range to electricity. If the quantum dot size is smaller than 0.5 nm, bandgap (forbidden band) of the inorganic material becomes larger, and it is possible that only the light of shorter wavelength side can be absorbed. If the quantum dot size is larger than 5 nm, energy level of quantum dots will not be discretized, and the quantum effects may not be exhibited. Here, the quantum dot size refers to the diameter of a quantum dot, which can be measured by using a transmission electron microscope (TEM). The bandgap refers to a difference between the ground state energy level of the conduction band and the energy level at the top of the valence band. The conduction band refers to an empty band at the top of the bandgap in a system having a bandgap, and the valence band refers to an energy band occupied by valence electrons in an insulator or semiconductor. The quantum effect refers to an effect that the nature of waves appears more prominently when electrons are confined in a quantum dot of nano-meter size.

The quantum dots as such can be manufactured by known methods described in various articles. By way of example, quantum dots of cadmium sulfide (CdS) may be manufactured in accordance with the methods described in: Journal of the American Chemical Society, (US), American Chemical Society, 1993, Vo. 115, pp. 8706-8715; The Journal of Physical Chemistry A, (US), American Chemical Society, 1994, Vol. 98, p. 3183; Journal of the American Chemical Society, (US), American Chemical Society, 2001, Vol. 123, pp. 183-184; or The Journal of Physical Chemistry A, (US), American Chemical Society, 2003, Vol. 107, p. 14154. Quantum dots of cadmium selenide (CdSe) may be manufactured in accordance with the methods described in: The Journal of Physical Chemistry B, (US), American Chemical Society, 1999, Vol. 103, p. 3065; or Journal of the American Chemical Society, (US), American Chemical Society, 1993, Vol. 115, pp. 8706-8715. Quantum dots of lead sulfide (PbS) or lead selenide (PbSe) may be manufactured in accordance with the methods described in: The Journal of Physical Chemistry B, (US), American Chemical Society, 2002, Vol. 106, p. 10634; or Journal of the American Chemical Society, (US), American Chemical Society, 2004, Vol. 126, p. 11752. Quantum dots of antimony sulfide (Sb₂S₃) may be manufactured in accordance with the method described in JP 2007-273984A. Quantum dots of indium arsenide (InAs) may be manufactured in accordance with the method described in The Journal of Physical Chemistry B, (US), American Chemical Society, 2006, Vol. 110, pp. 25451-25454.

It is preferred that the quantum dots of inorganic material 24 include molecules having interlocking group as a functional group that provides physical and electrical coupling to porous semiconductor layer 20. Examples of interlocking group include carboxyl group, alkoxy group, hydroxyl group, sulfonate group, ester group, mercapto group and phosphonyl group, and molecules having interlocking group may have one or two of these interlocking groups. Specific examples are: dicarboxylic acid such as malonic acid, malic acid and maleic acid; and mercaptoacetic acid having carboxylic acid and mercapto group. Quantum dots of inorganic material 24 are physically coupled to the surface of porous semiconductor layer 20 by means of the interlocking group of these molecules, and firmly carried on porous semiconductor layer 20. Further, the interlocking group of these molecules provides electric coupling, facilitating movement of excited electrons between organic molecules 26 in the excited state and the conduction band of porous semiconductor layer 20. Therefore, electron injection from organic molecules 26 in the excited state to porous semiconductor layer 20 takes place with higher efficiency.

Table 1 shows energy levels of highest occupied molecular orbital (hereinafter referred to as HOMO) and lowest unoccupied molecular orbital (hereinafter referred to as LUMO) of quantum dots of typical inorganic material 24. Here, HOMO refers to molecular orbital with highest energy level occupied by electrons, when electrons are allocated to molecular orbits in order, starting from the lower energy level, and LUMO refers to molecular orbital with lowest energy level unoccupied by electrons, when electrons are allocated to molecular orbits in order, starting from the lower energy level. The energy levels of HOMO and LUMO in the specification were measured by AC-3 (trade name, manufactured by Riken Keiki Co. Ltd.) and an absorbance measuring device (trade name: UV-2000, manufactured by Shimadzu Corporation).

**Table 1**

| | HOMO (V) | LUMO (V) |
|---|---|---|
| Cadmium sulfide (CdS) | -6.4 | -3.1 |
| Cadmium selenide (CdSe) | -6.0 | -3.4 |
| Lead sulfide (PbS) | -5.5 | -4.1 |
| Indium arsenide (InAs) | -5.5 | -4.1 |
| Cadmium telluride (CdTe) | -5.3 | -2.8 |

Organic molecule 26 has an aromatic ring. Here, the aromatic ring refers to a cyclic unsaturated organic compound, including aromatic hydrocarbon consisting only of hydro carbon, and heteroaromatic compound having an element other than carbon in the ring structure. Aromatic hydrocarbon includes benzene ring, and condensed benzene ring such as naphthalene ring or pyrene ring. Heteroaromatic compound includes aromatic hetero ring such as pyridine ring or pyrrole ring, and pyridine or furan in which carbon atom in the ring structure of benzene ring or naphthalene ring is replaced by a hetero atom.

Since organic molecule 26 has an aromatic ring with π bond, the HOMO energy level of organic molecule 26 comes closer to the vacuum level as compared with a molecule not having the aromatic ring. Therefore, holes in the valence band in the quantum dots of inorganic material 24 tend to be reduced more easily. As a result, electrons and holes come to be more reliably separated, and charge recombination can be prevented. Therefore, the life of excited electrons in inorganic material 24 can be made longer, and electron injection to inorganic material 24 comes to be done with higher efficiency from the viewpoint of energy balance. By way of example, quantum dots described in Patent Document 3 include trioctyl phosphine oxide as a ligand. Here, HOMO energy level of trioctyl phosphine oxide is about -6.5eV. In contrast, HOMO energy level of organic molecules 26 having aromatic ring is about -6.2eV to about -5.0eV. Therefore, it can be understood that electron injection to inorganic material 24 can be done with higher efficiency from the viewpoint of energy balance when organic molecules 26 are used than when trioctyl phosphine oxide is used.

Preferably, organic molecule 26 includes, as constituent element, hydrogen, boron, carbon, nitrogen, oxygen, halogen family of elements, silicon, phosphorus or sulfur, that is, an element other than metal element. Organic molecule 26 containing element other than metal element as the constituent element attains high incident photon-to-current conversion efficiency. Further, light absorber 22 as the photosensitizer can be manufactured in simpler and less expensive manner than when organic metal molecule or organic metal complex, which are difficult to synthesize and are expensive, is used. When organic molecule 26 contains metal element and has an aromatic ring, it is often the case that organic molecule 26 is a metallo-organic complex. Metallo-organic complex has ligands same in number as the coordination number of metal and, therefore, it generally has high molecular weight. Therefore, LUMO energy level in organic molecule 26 becomes lower, and electrons in inorganic material 24 excited by light absorption tend to move more easily to the metallo-organic complex. As a result, exit of electrons to the outside is hindered, possibly decreasing incident photon-to-current conversion efficiency.

It is preferred that organic molecule 26 has, in the molecule, an interlocking group as a functional group providing physical and electrical coupling to inorganic material 24. Examples of the interlocking group include: carboxyl group, alkoxy group, hydroxyl group, sulfonate group, ester group, mercapto group, phosphonyl group and amino group. Organic molecule 26 is physically coupled with the surface of inorganic material 24 by means of the interlocking group, whereby it is firmly carried on inorganic material 24. Further, the interlocking group provides electric coupling that facilitates movement of excited electrons between inorganic material 24 and organic molecules 26. Therefore, electron injection from organic molecules 26 to inorganic material 24 takes place with higher efficiency.

It is preferred that organic molecule 26 has a basic hetero ring or an electron donating group, and an acidic hetero ring or an electron accepting group. It is more preferable that the acidic hetero ring or the electron accepting group is coupled with inorganic material 24. Here, the basic hetero ring refers to a hetero ring having high electron donating ability, and examples are benzothiazole, benzo oxazole, benzimidazole, indolenine and quinoline. The electron donating group refers to a functional group having higher electron donating ability than hydrogen atom, such as hydroxyl group, ester group, amino group or methyl group. The acidic hetero ring refers to a hetero ring having high electron accepting ability, and examples are rhodanine, thio oxazolidone, thiohydantoin and thiobarbituric acid. The electron accepting group refers to a functional group having higher electron accepting ability than hydrogen atom, such as trifluoromethyl group, trichloromethyl group, nitro group, cyano group, aldehyde group, carboxyl group and sulfone group.

When organic molecule 26 has a basic hetero ring or an electron donating group, and an acidic hetero ring or an electron accepting group and the acidic hetero ring or the electron accepting group is coupled with inorganic material 24, electron injection from organic molecules 26 to inorganic material 24 takes place with higher efficiency, and higher incident photon-to-current conversion efficiency can be attained. The reason is that HOMO electron cloud locally exists on the basic hetero ring or electron donating group while LUMO electron cloud locally exists on the acidic hetero ring or electron accepting group, with their orbits spatially separated from each other. Specifically, electron excitation by light absorption mainly involves transition of electrons from HOMO to LUMO. Therefore, in the organic molecules in which electron cloud of HOMO and electron cloud of LUMO are spatially separated in the molecule, charges move more efficiently in the molecules when light is absorbed and, hence, high performance as a photosensitizer can be realized.

The molecular weight of organic molecule 26 is at most 500. This means that the size of organic molecule 26 becomes smaller than 1 nm, and the number of organic molecules 26 held on one inorganic material 24 comes to be within a preferable range. Thus, efficiency of electron injection from organic molecules 26 to inorganic material 24 can further be improved. If the molecular weight of organic molecule 26 is larger than 500, the size of organic molecule 26 comes to be 1 nm or larger, which is substantially the same size as inorganic material 24. Then, the number of organic molecules 26 carried by one inorganic material 24 would be reduced.

In the following, specific structures of typical examples of organic molecules 26 will be given.
Compound Example (1) 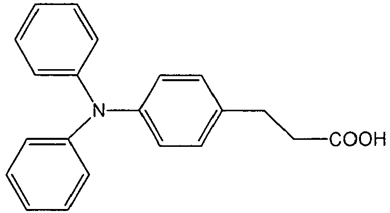
Compound Example (2) 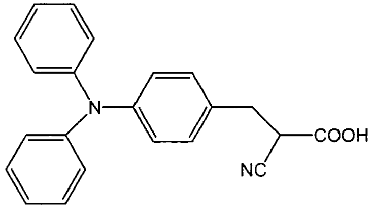
Compound Example (3) 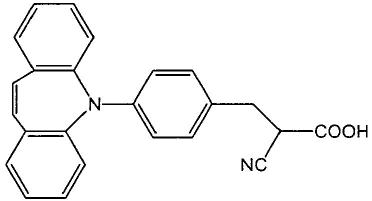
Compound Example (4) 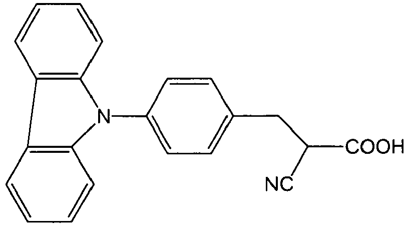
Compound Example (5) 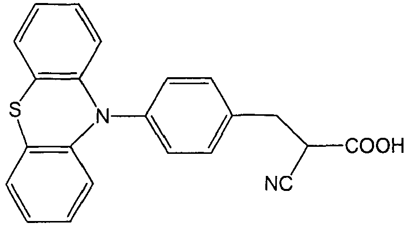
Compound Example (6) 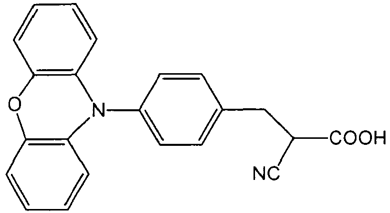
Compound Example (7) 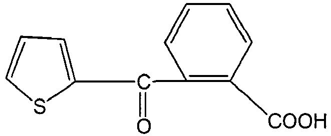
Compound Example (8) 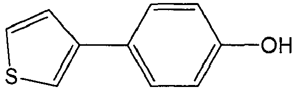
Compound Example (9) 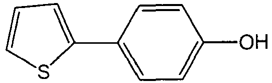
Compound Example (10) 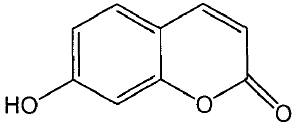
Compound Example (11) 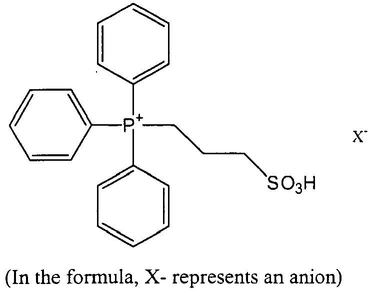
Compound Example (12) 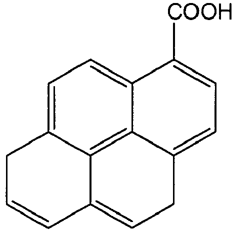
Compound Example (13) 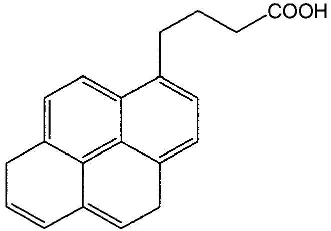
Compound Example (14) 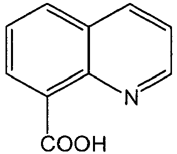
Compound Example (15) 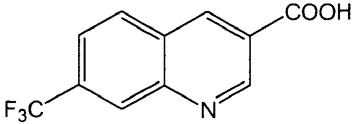
Compound Example (16) 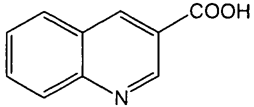
Compound Example (17) 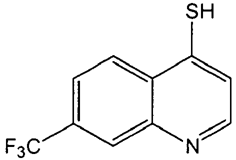
Compound Example (18) 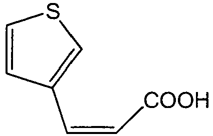
Compound Example (19) 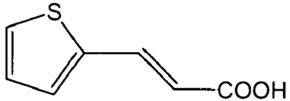
Compound Example (20) 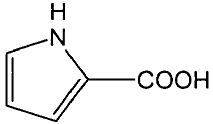
Compound Example (21) 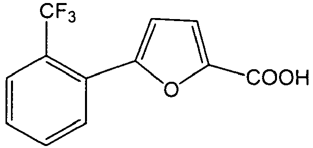
Compound Example (22) 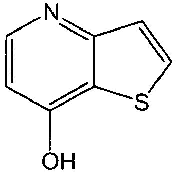
Compound Example (23) 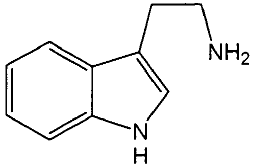
Compound Example (24) 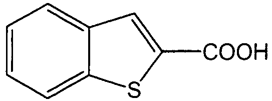
Compound Example (25)

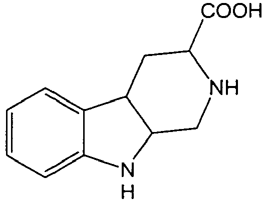

Table 2 shows HOMO and LUMO energy levels and molecular weights of typical compound examples given above.

**Table 2**

| Compound Example No. | HOMO(V) | LUMO(V) | Molecular weight |
|---|---|---|---|
| Compound Example (2) | -5.57 | -2.12 | 342.79 |
| Compound Example (7) | -6.13 | -2.93 | 232.26 |
| Compound Example (8) | -5.59 | -2.32 | 176.24 |
| Compound Example (9) | -5.63 | -2.49 | 176.24 |
| Compound Example (10) | -6.04 | -2.71 | 162.14 |
| Compound Example (14) | -6.23 | -2.86 | 173.17 |
| Compound Example (16) | -6.23 | -2.86 | 173.17 |
| Compound Example (17) | -6.23 | -2.86 | 229.22 |
| Compound Example (21) | -6.15 | -3.01 | 256.18 |
| Compound Example (25) | -5.62 | -1.61 | 218.25 |

The combination of inorganic material 24 and organic molecules 26 is preferably selected such that LUMO energy level of organic molecules 26 becomes higher than the ground state energy level of the conduction band of inorganic material 24 and, more preferably that HOMO energy level of organic molecules 26 becomes higher than the energy level at the top of the valence band of inorganic material 24. Here, the ground state energy level of the conduction band of inorganic material 24 corresponds to the LUMO energy level of inorganic material 24, and the energy level at the top of the valence band of inorganic material 24 corresponds to the HOMO energy level of inorganic material 24.

In light absorber 22 formed of the combination of inorganic material 24 and organic molecules 26 selected such that LUMO energy level of organic molecules 26 becomes higher than the ground state energy level of the conduction band of inorganic material 24, transition of electrons excited in inorganic material 24 to organic molecules 26 is prevented and, therefore, life of the excited electrons can be made longer. Further, in light absorber 22 formed of the combination of inorganic material 24 and organic molecules 26 selected such that HOMO energy level of organic molecules 26 becomes higher than the the energy level at the top of the valence band of inorganic material 24, electron injection from organic molecules 26 to inorganic material 24 can be done with higher efficiency, and the holes in the valence band of inorganic material 24 are more easily reduced by the organic molecules 26. As a result, electrons and holes come to be more reliably separated, and charge recombination can be prevented. Therefore, the life of excited electrons in inorganic material 24 can be made even longer.

Further, preferably, organic molecule 26 is selected such that the difference between the HOMO energy level and the LUMO energy level of organic molecule 26 becomes larger than the bandgap of semiconductor compound as the constituent material of porous semiconductor layer 20. Then, the light absorbed in porous semiconductor layer 20 is prevented from being absorbed in organic molecules 26 and, therefore, more efficient photo-electric conversion becomes possible.

### (Method of Manufacturing Porous Semiconductor Layer 20)

Porous semiconductor layer 20 may be formed on conductive film 16 by a known method. By way of example, a method has been known in which a suspension containing semiconductor fine particles 5 is applied to conductive film 16 and at least dried or sintered. According to this method, first, semiconductor fine particles 5 are suspended in an appropriate solvent to provide a suspension. Available solvent includes: glyme-based solvent such as ethyleneglycol monomethylether, alcohol such as isopropyl alcohol, alcohol-mixed solvent such as isopropyl alcohol/toluene, and water. Further, in place of the suspension, commercially available titanium oxide paste (trade names: Ti-nanoxide series D/SP, D, T/SP or D/DP, manufactured by Soraronix) may be used. Thereafter, the suspension or the titanium oxide paste is applied to conductive film 16 by a known method such as doctor blade method, squeezee method, spin coating or screen printing, and the applied liquid is subjected to at least one of drying and sintering, whereby porous semiconductor layer 20 as a porous film can be formed. The temperature, time, atmosphere and the like necessary for drying or sintering may be appropriately set in accordance with the types of constituent material of conductive film 16 and of semiconductor fine particles 5 and, by way of example, the process is carried out in the atmosphere or in an inert gas atmosphere in a temperature range of 50°C to 800°C, for 10 seconds to 12 hours. Drying or sintering may be done once at one temperature, or it may be done twice or more at different temperatures. If porous semiconductor layer 20 is formed of a plurality of layers, suspensions of different types of semiconductor fine particles 5 as desired are prepared, and the process of applying and at least drying or sintering mentioned above is repeated by the number corresponding to the types of the suspensions, to form porous semiconductor layer 20. Though the thickness of porous semiconductor layer 20 formed in this manner is not specifically limited, preferable thickness is 0.1 µm to 100 µm. Porous semiconductor layer 20 should preferably have larger surface area, and particularly, 10m²/g to 200m²/g is preferred. Further, prior to the process for carrying quantum dots of inorganic material 24, a process for activating the surface of porous semiconductor layer 20 may be performed, in order to increase surface area of porous semiconductor layer 20 or to decrease defect level of semiconductor fine particles 5. One such activating process is dipping of porous semiconductor layer 20 in an aqueous solution of titanium tetrachloride, if the layer is formed of titanium oxide (TiO₂).

Thereafter, porous semiconductor layer 20 formed in the above-described manner is caused to carry quantum dots of inorganic material 24. The method to have porous semiconductor layer 20 carry quantum dots of inorganic material 24 is not specifically limited and any method generally used in the field of art may be used. By way of example, a method of dipping porous semiconductor layer 20 in a solution having quantum dots of inorganic material 24 dispersed therein (hereinafter referred to as "quantum dots dispersed solution"), a method of applying the quantum dots dispersed solution to the surface of porous semiconductor layer 20, or a method of forming quantum dots directly on porous semiconductor layer 20 as described in JP2007-273984A, may be used. If the method of dipping mentioned above is used, it is preferred to heat the quantum dots dispersed solution so that the quantum dots dispersed solution can reach deep inside the pores of porous semiconductor layer 20.

As to the solvent for dispersing the quantum dots in the quantum dots dispersed solution, any solvent generally used in the field of art may be used. Available examples include: alcohol, toluene, acetonitrile, tetrahydrofuran (THF), chloroform and dimethylformamide, or a mixed solvent containing two or more of these. Preferably, the solvent should be purified to have higher purity by a known purifying method such as distillation or drying. The concentration of quantum dots in the quantum dots dispersed solution may be set appropriately in accordance with various conditions such as the types of quantum dots and solvent used and the method how the quantum dots are carried. By way of example, the concentration is preferably at least 0.01 mmol/L and more preferably 0.1 mmol/L to 1mol/L. The time and number of dipping may be set appropriately in accordance with various conditions of the carrying process. By way of example, dipping may preferably be done once to five times, for about 0.2 to about 168 hours.

It is preferred to have the quantum dots that are not carried washed away after the carrying process. The solvent for washing is not specifically limited, and any solvent that does not dissolve the quantum dots may be used. Lower alcohol such as ethanol may be used. A solvent that have low boiling point and dries easily is preferred.

Next, the quantum dots of inorganic material 24 carried on porous semiconductor layer 20 in the above-described manner is processed to carry organic molecules 26.

The method to have the quantum dots carry organic molecules 26 is not specifically limited and any method generally used in the field of art may be used. By way of example, a method of dipping porous semiconductor layer 20 carrying the quantum dots in a solution having organic molecules 26 dissolved therein (organic molecule adsorbing solution), or a method of applying the organic molecule adsorbing solution to the surface of porous semiconductor layer 20 carrying the quantum dots may be used. When the organic molecule adsorbing solution is prepared, it is preferred to heat the organic molecule adsorbing solution, in order to improve solubility of organic molecules 26.

As to the solvent for dissolving organic molecules 26 in the organic molecule adsorbing solution, any solvent generally used in the field of art may be used. Available examples include: lower alcohol such as ethanol, ether, and acetone, or a mixed solvent containing two or more of these. Preferably, the solvent should be purified to have higher purity by a known purifying method such as distillation or drying. The concentration of organic molecules in the organic molecule adsorbing solution may be set appropriately in accordance with various conditions such as the types of organic molecules 26 and solvent used and the method how the organic molecules are carried. By way of example, the concentration is preferably at least 0.01 mmol/L and more preferably 0.1 mmol/L to 1mol/L. The time and number of dipping may be set appropriately in accordance with various conditions of the carrying process. By way of example, dipping may preferably be done once to ten times, for about 0.5 to about 168 hours.

It is preferred to have the organic molecules 26 that are not carried washed away after the carrying process. The solvent for washing is not specifically limited, and lower alcohol such as ethanol may be used. A solvent that have low boiling point and dries easily is preferred.

### [Counter Electrode 12]

Counter electrode 12 includes a substrate 30 having a conductive film 28 formed on its surface and a catalyst layer 32 formed on substrate 30, and it forms, with semiconductor electrode 10, a pair of electrodes.

Substrate 30 is not specifically limited, and any substrate that is substantially transparent and generally used for solar cell 1 in the field of art may be used. A substrate formed of a heat-resistant material such as ceramic or glass including soda-lime float glass or silica glass may be used. The thickness of substrate 30 is not specifically limited as long as appropriate mechanical strength is ensured for solar cell 1 and, preferably, it is 0.5 mm to 8 mm Conductive film 28 is not specifically limited, and any film formed of transparent conductive material may be used. For example, a film of indium tin oxide (ITO), tin oxide (SnO₂), fluorine-doped tin oxide (FTO), copper iodide (CuI) or zinc oxide (ZnO) may be used. Preferable thickness of conductive film 28 is 0.1 µm to 5 µm, and the film is formed on substrate 30 by a known method such as sputtering or spraying. As to substrate 30 and conductive film 28, use of a substrate 30 formed of soda-lime float glass having conductive film 28 of FTO deposited thereon (such as a product commercially available from Nippon Sheet Glass Co., Ltd.) is preferred.

Catalyst layer 32 is not specifically limited, and any layer generally used in the field of art may be used. A film of platinum, carbon black, Ketjen black, carbon nano tube or fullerene may be used. When a film formed of platinum is to be used as catalyst layer 32, the platinum film as catalyst layer 32 may be formed on substrate 30 having conductive film 28 formed thereon, by a known method such as vapor deposition, sputtering, thermal decomposition of chloroplatinic acid or electrodeposition. When a film formed of carbon such as carbon black, Ketjen black, carbon nano tube or fullerene is to be used as catalyst layer 32, a carbon film as catalyst layer 32 may be formed on substrate 30 having conductive film 28 formed thereon, by applying, for example, by screen printing, carbon paste prepared by dispersing the carbon in a solvent. The thickness of catalyst layer 32 is not specifically limited, and preferable thickness is 0.5 nm to 1000 nm. Though the form of catalyst layer 32 is not specifically limited, it should preferably have the form of a dense film, a porous film or a clustered film.

### [Carrier Transport Layer 14]

Carrier transport layer 14 includes a conductive material that can transport electrons, holes or ions. Available conductive material includes: an ion conductor such as polyelectrolysis solution or electrolysis solution including redox species; hole transport material such as polyvinyl carbazole or triphenylamine; electron transport material such as fullerene derivative or tetranitro fluorenon; a conductive polymer such as polythiophene or polypyrrole; and an inorganic p-type semiconductor such as copper iodide, copper thiocyanate or nickel oxide.

Among these conductive materials, use of an ion conductor is preferred and use of electrolysis solution including redox species is particularly preferred. The redox species is not specifically limited and any one that can be generally used in a cell or a solar cell may be used, including I⁻/I³⁻ system, Br²⁻/Br³⁻ system, Fe²⁺/Fe³⁺ system, Na₂Sx/Na₂S system, (SCN)₂/SCN⁻ system, (SeCN)₂/SeCN⁻ system, Co²⁺/Co³⁺ system, or quinone/hydroquinone system species.

Typical examples of the redox species mentioned above are as follows. Specifically, as the I⁻/I³⁻ system, a combination of metallic iodide such as lithium iodide (LiI), sodium iodide (NaI), potassium iodide (KI) or calcium iodide (CaI₂) and iodine (I₂), as well as a combination of tetraalkyl ammonium salt such as tetraethyl ammonium iodide (TEAI), tetrapropyl ammonium iodide (TPAI), tetrabutyl ammonium iodide (TBAI) or tetrahexyl ammonium iodide (THAI) and iodine (I₂) may be used. As the Br²⁻/Br³⁻ system, a combination of metallic bromide such as lithium bromide (LiBr), sodium bromide (NaBr), potassium bromide (KBr) or calcium bromide (CaBr₂) and bromine (Br₂) may be used. As the Fe²⁺/Fe³⁺ system, a combination of iron chloride (II) (FeCl₂) and iron chloride (III) (FeCl₃) or a combination of potassium ferrocyanide (K₄[Fe(CN)₆]) and potassium ferricyanide (K₃[Fe(CN)₆]) may be used. As the Na₂Sx/Na₂S system, a combination of sodium sulfide (Na₂S) and sulfur (S) may be used. As the (SCN)₂/SCN⁻ system, a combination of lead thiocyanate (Pb(SCN)₂) and sodium thiocyanate (NaSCN) is known. Among these, use of a combination of lithium iodide (LiI) and iodine (I₂), or a combination of sodium sulfide (Na₂S) and sulfur (S) is preferred from the viewpoint of attaining higher incident photon-to-current conversion efficiency.

As regards the redox species described above, it is preferred that HOMO energy level of organic molecules 26 is lower than the redox potential or Fermi level of the redox species. Then, more efficient electron injection to organic molecules 26 in the oxidized state becomes possible, and the charge exchange reaction rate between light absorber 22 and the redox species can be increased. Here, Fermi level refers to a level at which statistically the number of electrons becomes 1/2.

The electrolysis solution containing the redox species includes an additive as needed. The additive may include: nitrogen-containing aromatic compound such as t-butyl pyridine (TBP); or imidazole salt such as dimethyl propyl imidazole iodide (DMPII), methyl propyl imidazole iodide (MPII), ethylmethyl imidazole iodide (EMII), ethyl imidazole iodide (EII) or hexylmethyl imidazole iodide (HMII). By adding such an additive to the electrolysis solution containing redox species, an effect of increasing speed of movement of redox species can be attained.

When the electrolysis solution containing the redox species described above is used as the conductive material, an electrolysis solution is prepared using a solvent for dissolving the electrolysis solution. As the solvent, a carbonate compound such as propylene carbonate, a nitrile compound such as acetonitrile, alcohol such as ethanol, water, or an aprotic polar material may be used. Among these, a carbonate compound or a nitrile compound is preferably used. Two or more of these solvents may be mixed for use. Preferable concentration of redox species in the electrolysis solution is 0.001 mol/L to 1.5 mol/L and more preferable concentration is 0.01 mol/L to 0.7 mol/L.

Table 3 shows redox potentials of typical examples of the electrolysis solution described above.

**Table 3**

| | Redox potential (V) |
|---|---|
| (SCN)₂/SCN⁻ system | -5.56 |
| Br²⁻ /Br³⁻ system | -5.50 |
| (SeCN)₂/SeCN⁻ system | -5.29 |
| Fe²⁻/Fe³⁻ system | -5.25 |
| I⁻/I³⁻ system | -5.10 |
| Co²⁺ /Co³⁺ system | -5.00 |
| (FeCN)³⁻/(FeCN)⁴⁻ system | -4.65 |
| Na₂Sₓ/Na₂S system | -4.35 |

Preferably, a spacer is provided between semiconductor electrode 10 and counter electrode 12, to prevent short-circuit caused by a contact between the electrodes. As the spacer, a polymer film such as polyethylene film may be used. Though the thickness of the film is not specifically limited, preferable thickness is 10 µm to 50 µm.

### <Operation>

Solar cell 1 in accordance with the present embodiment operates in the following manner. When solar cell 1 is irradiated with sunlight, organic molecules 26 of light absorber 22 on the surface of porous semiconductor layer 20 absorb light, whereby electrons in organic molecules 26 are excited. Excited electrons move through quantum dots of inorganic material 24 to porous semiconductor layer 20, and then move through conductive film 16 and an electric circuit (not shown) to conductive film 28. The electrons that have moved to conductive film 28 reduce the redox species in carrier transport layer 14, and the reduced redox species causes the electrons to move to porous semiconductor layer 20, whereby oxidized organic molecules 26 are reduced. By repeating such a process, electric energy continuously converted from optical energy through the flow of electrons can be obtained.

### <Functions/Effects>

According to the present embodiment, light absorber 22 as the photosensitizer includes inorganic material 24 carrying organic molecules 26 as molecules each having an aromatic ring. Since organic molecules 26 have aromatic rings, holes in the valence band of inorganic material 24 tend to be more easily reduced, whereby electrons and holes are more reliably separated, and charge recombination can be prevented. Therefore, the life of excited electrons in inorganic material 24 can be made longer, and electron injection to inorganic material 24 highly efficient in view of energy balance becomes possible. As a result, light absorber 22 as the photosensitizer including inorganic material 24 carrying organic molecules 26 as such comes to have longer durability life and attains high incident photon-to-current conversion efficiency.

According to the present embodiment, solar cell 1 includes: a semiconductor electrode 10 including a substrate 18 having a conductive film 16 formed on its surface, and porous semiconductor layer 20 formed on substrate 18; a counter electrode 12 including a substrate 30 having a conductive film 28 formed on its surface; and a carrier transport layer 14 including a conductive material, posed between semiconductor electrode 10 and counter electrode 12; wherein the above-mentioned light absorber 22 is carried on the surface of porous semiconductor layer 20. Since light absorber 22 described above is provided, an inexpensive solar cell 1 having high incident photon-to-current conversion coefficient and long durability life can be obtained.

Though transparent substrates are used both for substrates 18 and 30 in the embodiment above, the substrate is not limited to the above, and either one may not be transparent, considering the incident direction of light. In that case, a film formed of a transparent or non-transparent conductive material corresponding to the transparency of substrates 18 and 30 may be used for conductive films 16 and 28. For instance, if substrate 30 is not transparent, a film formed of a non-transparent conductive material may be used for the corresponding conductive film 28. By way of example, a film formed of an N-type or P-type elemental semiconductor (silicon, germanium or the like), a compound semiconductor such as gallium arsenide (GaAs), indium phosphide (InP), zinc selenide (ZnSe) or cesium sulfide (CsS), metal such as gold, platinum, silver, copper or aluminum, or a metal of high melting point such as tantalum or tungsten may be used.

The embodiments as have been described here are mere examples and should not be interpreted as restrictive. The scope of the present invention is determined by each of the claims with appropriate consideration of the written description of the embodiments and embraces modifications within the meaning of, and equivalent to, the languages in the claims.

### Examples

In the following, the embodiment above will be specifically described with reference to examples and comparative examples. It is noted that the embodiment is not limited to the examples below as long as the gist of the invention is not exceeded. In the description of examples and comparative examples, the thickness of each layer was measured by using SURFCOM 1400A (trade name, manufactured by Tokyo Seimitsu Co. Ltd.), the HOMO and LUMO energy levels were measured by using AC-3 (trade name, manufactured by Riken Keiki Co. Ltd.) and an absorbance measuring device (trade name: UV-2000, manufactured by Shimadzu Corporation), and the redox potential was measured by using a cyclic voltammetry (trade name: PG STAT12, manufactured by Autolab).

### (Example 1)

### [Manufacturing of Solar Cell]

### (Fabrication of Semiconductor Electrode)

Commercially available titanium oxide paste (trade name: Ti-Nanoxide D/SP, manufactured by Soraronix, average particle size: 13 nm) was applied to a glass substrate (manufactured by Nippon Sheet Glass Co., Ltd.) as a substrate having a fluorine-doped tin oxide (FTO) film formed as a conductive film, by doctor blade method. Thereafter, the glass substrate was pre-dried for 30 minutes at 300°C, and thereafter sintered for 40 minutes at 500°C, and the pre-drying and sintering were repeated again. As a result, a porous semiconductor layer of titanium oxide film having the thickness of 12 µm was formed on the glass substrate.

According to the method described in Journal of the American Chemical Society (US), American Chemical Society, 1993, Vol. 115, pp. 8706-8715, quantum dots of cadmium sulfide (CdS) to be used as the inorganic material were manufactured. The quantum dots had the HOMO energy level of -6.4 V and the LUMO energy level of -3.1 V.

The quantum dots of cadmium sulfide (CdS) manufactured as described above were dispersed in ethanol to attain the concentration of 0.5 mmol/L, to prepare the quantum dots dispersed solution. The glass substrate having the porous semiconductor layer of titanium oxide film fabricated in the above-described manner was dipped and kept in the quantum dots dispersed solution for 12 hours, so that the quantum dots were carried by the porous semiconductor layer. Thereafter, the glass substrate was taken out from the quantum dots dispersed solution, washed with ethanol (manufactured by Aldrich Chemical Co.), and dried, whereby a porous semiconductor layer carrying quantum dots was formed.

Thereafter, organic molecules represented by Compound Example (14) (manufactured by Aldrich Chemical Co.) were dissolved in ethanol to attain the concentration of 0.2 mmol/L, to prepare the organic molecule adsorbing solution. The glass substrate having the porous semiconductor layer carrying the quantum dots fabricated in the above-described manner was dipped and kept in the organic molecule adsorbing solution for 12 hours, whereby the quantum dots came to carry the organic molecules. Thereafter, the glass substrate was taken out from the organic molecule adsorbing solution, washed with ethanol and dried, whereby a porous semiconductor layer carrying the organic molecules and quantum dots was formed. The organic molecules represented by Compound Example (14) had the HOMO energy level of -6.23 V and the LUMO energy level of -2.86 V.

### (Fabrication of Counter Electrode)

Using a vapor deposition apparatus (trade name: ei-5, manufactured by ULVAC, Inc.), on a glass substrate (manufactured by Nippon Sheet Glass Co., Ltd.) as a substrate having a fluorine-doped tin oxide (FTO) film formed as a conductive film, platinum was vapor-deposited at 0.1 Å (angstrom)/sec, whereby a counter electrode having a catalyst layer of platinum film of 1 µm in thickness was fabricated.

### (Preparation of I⁻/I³⁻ System Electrolysis Solution)

To 1L of acetonitrile (manufactured by Aldrich Chemical Co.), 0.1 mol of lithium iodide (LiI, manufactured by Aldrich Chemical Co.), 0.03 mol of iodine (I₂, manufactured by Aldrich Chemical Co.), 0.5 mol of t-butylpyridine (TBP, manufactured by Aldrich Chemical Co.), and 0.3 mol of dimethyl propyl imidazol iodide (DMPII, manufactured by Shikoku Chemicals Corporation) were added, to prepare the I⁻/I³⁻ system electrolysis solution to be used as the carrier transport layer. The redox potential of I⁻/I³⁻ system electrolysis solution was -5.10V.

### (Fabrication of Solar Cell)

The semiconductor electrode and the counter electrode fabricated in the above-described manner were superposed with a spacer for preventing short-circuit interposed, and the I⁻/I³⁻ system electrolysis solution was introduced through a space of each electrode. Thereafter, side surfaces were sealed by a resin (trade name: 31X-101C, manufactured by Three Bond Co. Ltd.), and leads were attached to the electrodes, whereby a solar cell of Example 1 was manufactured.

### (Example 2)

A solar cell of Example 2 was manufactured in the similar manner as Example 1 except that Compound Example (16) was used as the organic molecules.

### (Example 3)

A solar cell of Example 3 was manufactured in the similar manner as Example 1 except that Compound Example (17) was used as the organic molecules.

### (Example 4)

A solar cell of Example 4 was manufactured in the similar manner as Example 1 except that Compound Example (21) was used as the organic molecules.

### (Example 5)

A solar cell of Example 5 was manufactured in the similar manner as Example 1 except that an Na₂Sₓ/Na₂S system electrolysis solution prepared in the manner as described below was used as the carrier transport layer.

### (Preparation of Na₂Sₓ/Na₂S System Electrolysis Solution)

To 1L of pure water, 2 mol of sodium sulfide (Na₂S, manufactured by Aldrich Chemical Co.), and 3 mol of sulfur (manufactured by Aldrich Chemical Co.) were added, to prepare the Na₂Sₓ/Na₂S system electrolysis solution to be used as the carrier transport layer. The Na₂Sₓ/Na₂S system electrolysis solution had the redox potential of -4.35 V.

### (Example 6)

A solar cell of Example 6 was manufactured in the similar manner as Example 1 except that Compound Example (16) was used as the organic molecules and an Na₂Sₓ/Na₂S system electrolysis solution was used as the carrier transport layer.

### (Example 7)

A solar cell of Example 7 was manufactured in the similar manner as Example 1 except that Compound Example (17) was used as the organic molecules and an Na₂Sₓ/Na₂S system electrolysis solution was used as the carrier transport layer.

### (Example 8)

A solar cell of Example 8 was manufactured in the similar manner as Example 1 except that Compound Example (21) was used as the organic molecules and an Na₂Sₓ/Na₂S system electrolysis solution was used as the carrier transport layer.

### (Example 9)

A solar cell of Example 9 was manufactured in the similar manner as Example 1 except that quantum dots of cadmium selenide (CdSe) manufactured in accordance with the method described in Journal of the American Chemical Society, (US), American Chemical Society, 1993, Vol. 115, pp. 8706-8715 were used as the inorganic material and that Compound Example (2) was used as the organic molecules. The quantum dots had the HOMO energy level of -6.0V and the LUMO energy level of -3.4 V.

### (Example 10)

A solar cell of Example 10 was manufactured in the similar manner as Example 1 except that quantum dots of cadmium selenide (CdSe) manufactured in the manner as described above were used as the inorganic material and Compound Example (8) was used as the organic molecules.

### (Example 11)

A solar cell of Example 11 was manufactured in the similar manner as Example 1 except that quantum dots of cadmium selenide (CdSe) manufactured in the manner as described above were used as the inorganic material and Compound Example (9) was used as the organic molecules.

### (Example 12)

A solar cell of Example 12 was manufactured in the similar manner as Example 1 except that quantum dots of cadmium selenide (CdSe) manufactured in the manner as described above were used as the inorganic material and Compound Example (21) was used as the organic molecules.

### (Example 13)

A solar cell of Example 13 was manufactured in the similar manner as Example 1 except that quantum dots of cadmium selenide (CdSe) manufactured in the manner as described above were used as the inorganic material, Compound Example (2) was used as the organic molecules and an Na₂Sₓ/Na₂S system redox electrolysis solution was used as the carrier transport layer.

### (Example 14)

A solar cell of Example 14 was manufactured in the similar manner as Example 1 except that quantum dots of cadmium selenide (CdSe) manufactured in the manner as described above were used as the inorganic material, Compound Example (8) was used as the organic molecules and an Na₂Sₓ/Na₂S system redox electrolysis solution was used as the carrier transport layer.

### (Example 15)

A solar cell of Example 15 was manufactured in the similar manner as Example 1 except that quantum dots of cadmium selenide (CdSe) manufactured in the manner as described above were used as the inorganic material, Compound Example (9) was used as the organic molecules and an Na₂Sₓ/Na₂S system redox electrolysis solution was used as the carrier transport layer.

### (Example 16)

A solar cell of Example 16 was manufactured in the similar manner as Example 1 except that quantum dots of cadmium selenide (CdSe) manufactured in the manner as described above were used as the inorganic material, Compound Example (21) was used as the organic molecules and an Na₂Sₓ/Na₂S system redox electrolysis solution was used as the carrier transport layer.

### (Example 17)

A solar cell of Example 17, not forming part of the invention, was manufactured in the similar manner as Example 1 except that organic metal molecules (molecular weight: 705.64) represented by Compound Example (26) were used in place of the organic molecules.

Compound Example (26)

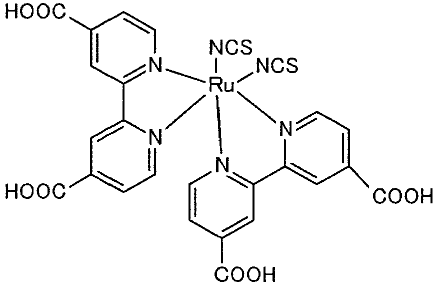

### (Example 18)

A solar cell of Example 18 was manufactured in the similar manner as Example 1 except that an (SCN)₂/SCN⁻ system electrolysis solution prepared in the manner as described below was used as the carrier transport layer, quantum dots of cadmium selenide (CdSe) manufactured in the manner as described above were used as the inorganic material, and Compound Example (21) was used as the organic molecules.

### (Preparation of (SCN)₂/SCN⁻ System Electrolysis Solution)

To 50 mL of acetonitrile (manufactured by Aldrich Chemical Co.), 2.5 mmol of lead thiocyanate (Pb(SCN)₂, manufactured by Aldrich Chemical Co.) was added and cooled to 0°C. To this solution, a solution prepared by adding 2.5 mmol of bromine (Br₂, manufactured by Aldrich Chemical Co.) to 25 mL of acetonitrile was added little by little and mixed until the color derived from bromine disappeared. Thereafter, lead bromide (PbBr₂) generated at the time of mixing the solution was filtered out, and to the filtered solution, a solution prepared by adding 10 mmol of sodium thiocyanate (NaSCN, manufactured by Alfer Aesar) to 25 mL of acetonitrile was added, to prepare the (SCN)₂/SCN⁻ system electrolysis solution to be used as the carrier transport layer. The (SCN)₂/SCN⁻ system electrolysis solution had the redox potential of -5.56 V.

### (Example 19)

A solar cell of Example 19 was manufactured in the similar manner as Example 1 except that quantum dots of cadmium selenide (CdSe) manufactured in the manner as described above were used as the inorganic material, and Compound Example (7) was used as the organic molecules.

### (Example 20)

A solar cell of Example 20 was manufactured in the similar manner as Example 1 except that quantum dots of cadmium selenide (CdSe) manufactured in the manner as described above were used as the inorganic material, and Compound Example (10) was used as the organic molecules.

### (Comparative Example 1)

A solar cell of Comparative Example 1 was manufactured in the similar manner as Example 1 except that trioctyl phosphine oxide (TOPO, molecular weight: 386.63) was used as the organic molecules.

### (Comparative Example 2)

A solar cell of Comparative Example 2 was manufactured in the similar manner as Example 1 except that organic molecules were not carried by the quantum dots of the inorganic material.

Table 4 shows characteristics of organic molecules (type, molecular weight, HOMO and LUMO energy levels), characteristics of inorganic materials (type, HOMO and LUMO energy levels) and characteristics of redox electrolysis solution (type and redox potential) of Examples 1 to 16, 18-20, Example 17 not forming part of the invention, and Comparative Examples 1 and 2.

**Table 4**

| | Organic Molecules | | | | Inorganic materials | | | Redox electrolysis solution | |
|---|---|---|---|---|---|---|---|---|---|
| | Type (Compound Example No.) | Molecular weight | HOMO (V) | LUMO (V) | Type | HOMO (V) | LUMO (V) | Type | Redox potential (V) |
| Example 1 | 14 | 173.17 | -6.23 | -2.86 | CdS | -6.4 | -3.1 | I⁻/I³⁻ system | -5.10 |
| Example 2 | 16 | 173.17 | -6.23 | -2.86 | | | | | |
| Example3 | 17 | 229.22 | -6.23 | -2.86 | | | | | |
| Example 4 | 21 | 256.18 | -6.15 | -3.01 | | | | | |
| Example 5 | 14 | 173.17 | -6.23 | -2.86 | | | | Na₂Sₓ/Na₂S system | -4.35 |
| Example 6 | 16 | 173.17 | -6.23 | -2.86 | | | | | |
| Example 7 | 17 | 229.22 | -6.23 | -2.86 | | | | | |
| Example 8 | 21 | 256.18 | -6.15 | -3.01 | | | | | |
| Example 9 | 2 | 342.79 | -5.57 | -2.12 | CdSe | -6.0 | -3.4 | I⁻/I³⁻ system | -5.10 |
| Example 10 | 8 | 176.24 | -5.59 | -2.32 | | | | | |
| Example 11 | 9 | 176.24 | -5.63 | -2.49 | | | | | |
| Example 12 | 21 | 256.18 | -6.15 | -3.01 | | | | | |
| Example 13 | 2 | 342.79 | -5.57 | -2.12 | | | | Na₂Sₓ/Na₂S system | -4.35 |
| Example 14 | 8 | 176.24 | -5.59 | -2.32 | | | | | |
| Example 15 | 9 | 176.24 | -5.63 | -2.49 | | | | | |
| Example 16 | 21 | 256.18 | -6.15 | -3.01 | | | | | |
| Example 17 | 26 | 705.64 | - | - | CdS | -6.4 | -3.1 | I⁻/I³⁻ system | -5.10 |
| Example 18 | 21 | 256.18 | -6.15 | -3.01 | CdSe | -6.0 | -3.4 | (SCN)₂/SCN⁻ system | -5.56 |
| Example 19 | 7 | 232.26 | -6.13 | -2.93 | CdSe | -6.0 | -3.4 | I⁻/I³⁻ system | -5.10 |
| Example 20 | 10 | 162.14 | -6.04 | -2.71 | | | | | |
| Comparative Example 1 | TOPO | 386.63 | -6.5 | - | CdS | -6.4 | -3.1 | I⁻/I³⁻ system | -5.10 |
| Comparative Example 2 | - | - | - | - | | | | | |

### [Evaluation]

The solar cells of Examples 1-16, and 18-20, Example 17 not forming part of the invention, and Comparative Examples 1 and 2 were irradiated with simulated sunlight having the intensity of AM 1.5 (1kW/m²) emitted by a solar simulator (trade name: WXS-155S, manufactured by WACOM), and the generated power (short-circuit current density (current value at voltage V = 0, Jsc), open voltage (voltage value at current I = 0, Voc), file factor (FF)) was measured by a current-voltage measuring device (trade name: CEP-2000, manufactured by Bunkokeiki Co., Ltd.). Further, the incident photon-to-current conversion efficiency (product of Jsc, Voc and FF) was calculated from the measurements. The results are as shown in Table 5.

**Table 5**

| | Electric power | | | photon-to-current conversion efficiency (%) |
|---|---|---|---|---|
| | Jsc (mA/cm²) | Voc (V) | FF | |
| Example 1 | 4.3 | 0.33 | 0.45 | 0.64 |
| Example 2 | 4.1 | 0.34 | 0.44 | 0.61 |
| Example 3 | 3.9 | 0.38 | 0.41 | 0.61 |
| Example 4 | 2.8 | 0.35 | 0.43 | 0.42 |
| Example 5 | 5. 3 | 0.41 | 0.45 | 0.98 |
| Example 6 | 5.2 | 0. 42 | 0.44 | 0.96 |
| Example 7 | 5.2 | 0.41 | 0.41 | 0.87 |
| Example 8 | 3. 9 | 0. 40 | 0.43 | 0.67 |
| Example 9 | 5.0 | 0.34 | 0.32 | 0.54 |
| Example 10 | 4.3 | 0. 35 | 0. 32 | 0.48 |
| Example 11 | 4. 2 | 0.35 | 0. 34 | 0.50 |
| Example 12 | 3.0 | 0. 36 | 0.35 | 0. 38 |
| Example 13 | 5. 4 | 0.44 | 0. 55 | 1.31 |
| Example 14 | 5.3 | 0.45 | 0.45 | 1.07 |
| Example 15 | 5.6 | 0.46 | 0.45 | 1.16 |
| Example 16 | 4.0 | 0.45 | 0.41 | 0.74 |
| Example 17 | 1.5 | 0.28 | 0.39 | 0.16 |
| Example 18 | 1.6 | 0.30 | 0.38 | 0.18 |
| Example 19 | 1.0 | 0.32 | 0.33 | 0.11 |
| Example 20 | 1.0 | 0. 36 | 0.31 | 0.11 |
| Comparative Example 1 | 1.5 | 0. 30 | 0. 33 | 0. 14 |
| Comparative Example 2 | 1. 5 | 0.29 | 0. 32 | 0.13 |

From the results shown in Table 5, it can be clearly understood that the solar cells of Examples 1-16,18-20 of the present invention are superior to solar cells of Comparative Examples 1 and 2 in the following points.

The porous semiconductor layers in the solar cells of Examples 1 to 20 carry inorganic materials carrying organic molecules as molecules having aromatic rings and, therefore, high incident photon-to-current conversion efficiency could be attained.

In contrast, the porous semiconductor layer in the solar cell of Comparative Example 1 carries an inorganic material carrying TOPO as molecule not having an aromatic ring and, therefore, incident photon-to-current conversion efficiency was low.

The porous semiconductor layer in the solar cell of Comparative Example 2 carries only the inorganic material and, therefore, incident photon-to-current conversion efficiency was low.

### INDUSTRIAL APPLICABILITY

The present invention can be used in the field of photosensitizers and cells, manufacturing, using and leasing photosensitizers attaining high incident photon-to-current conversion efficiency and having long durability life as well as solar cells using such photosensitizers.

## Claims

1. A solar cell (1), comprising:
a semiconductor electrode (10) including a first substrate (18) having a first conductive film (16) formed on its surface and a porous semiconductor layer (20) formed on the first substrate (18);
a counter electrode (12) including a second substrate (30) having a second conductive film (28) formed on its surface; and
a carrier transport layer (14) including conductive material, posed between said semiconductor electrode (10) and said counter electrode (12); wherein
said porous semiconductor layer (20) carries on its surface a photosensitizer containing inorganic material (24) carrying organic molecules (26) each having an aromatic ring, and molecular weight of said organic molecule (26) is at most 500.

2. The solar cell (1) according to claim 1, wherein energy level of highest occupied molecular orbital of said organic molecule (26) is lower than redox potential or Fermi level of said conductive material.

3. The solar cell (1) according to claim 1, wherein said porous semiconductor layer (20) is formed of a metal oxide semiconductor compound.

4. The solar cell (1) according to claim 3, wherein difference between the energy level of highest occupied molecular orbital and the energy level of lowest unoccupied molecular orbital of said organic molecule (26) is larger than difference between ground state energy level of the conduction band and energy level at the top of the valence band of said metal oxide semiconductor compound.

5. The solar cell (1) according to claim 3, wherein said metal oxide semiconductor compound is titanium oxide.

6. The solar cell (1) according to claim 1, wherein said organic molecule (26) has an interlocking group having a function of providing physical and electrical coupling to said inorganic material (24).

7. The solar cell (1) according to claim 1, wherein said inorganic material (24) and said organic molecule (26) are selected such that energy level of lowest unoccupied molecular orbital of said organic molecule (26) becomes higher than ground state energy level of conduction band of said inorganic material (24).

8. The solar cell (1) according to claim 1, wherein said inorganic material (24) and said organic molecule (26) are selected such that energy level of highest occupied molecular orbital of said organic molecule (26) becomes higher than energy level at the top of the valence band of said inorganic material (24).

9. The solar cell (1) according to claim 1, wherein said organic molecule (26) has a basic hetero ring or an electron donating group, and an acidic hetero ring or an electron accepting group.

10. The solar cell (1) according to claim 1, wherein said inorganic material (24) is selected from the group consisting of cadmium sulfide, cadmium selenide, lead sulfide, lead selenide, antimony sulfide, antimony selenide, indium arsenide, and indium gallium arsenide.

## Patentansprüche

1. Solarzelle (1), aufweisend:
eine Halbleiterelektrode (10), die ein erstes Substrat (18) mit einem auf dessen Oberfläche ausgebildeten ersten leitfähigen Film (16) und eine auf dem ersten Substrat (18) ausgebildete poröse Halbleiterschicht (20) umfasst;
eine Gegenelektrode (12), die ein zweites Substrat (30) mit einem auf dessen Oberfläche ausgebildeten zweiten leitfähigen Film (28) umfasst; und
eine ein leitfähiges Material enthaltende Trägertransportschicht (14), die zwischen der Halbleiterelektrode (10) und der Gegenelektrode (12) angeordnet ist; wobei
die poröse Halbleiterschicht (20) auf ihrer Oberfläche einen Photosensibilisator trägt, der ein anorganisches Material (24) enthält, das organische Moleküle (26) trägt, die jeweils einen aromatischen Ring aufweisen, und ein Molekulargewicht des organischen Moleküls (26) höchstens 500 ist.

2. Solarzelle (1) nach Anspruch 1, wobei ein Energieniveau eines höchsten besetzten Molekülorbitals des organischen Moleküls (26) niedriger als ein Redoxpotential oder Fermi-Niveau des leitfähigen Materials ist.

3. Solarzelle (1) nach Anspruch 1, wobei die poröse Halbleiterschicht (20) aus einer Metalloxid-Halbleiterverbindung gebildet ist.

4. Solarzelle (1) nach Anspruch 3, wobei eine Differenz zwischen dem Energieniveau eines höchsten besetzten Molekülorbitals und dem Energieniveau eines niedrigsten unbesetzten Molekülorbitals des organischen Moleküls (26) größer ist als eine Differenz zwischen einem Energieniveau des Grundzustands des Leitungsbands und einem Energieniveau am oberen Ende des Valenzbandes der Metalloxid-Halbleiterverbindung.

5. Solarzelle (1) nach Anspruch 3, wobei die Metalloxid-Halbleiterverbindung Titanoxid ist.

6. Solarzelle (1) nach Anspruch 1, wobei das organische Molekül (26) eine verkettende Gruppe aufweist, die eine Funktion zum Bereitstellen einer physikalischen und elektrischen Kopplung mit dem anorganischen Material (24) hat.

7. Solarzelle (1) nach Anspruch 1, wobei das anorganische Material (24) und das organische Molekül (26) so ausgewählt werden, dass ein Energieniveau eines niedrigsten unbesetzten Molekülorbitals des organischen Moleküls (26) höher wird als ein Energieniveau des Grundzustands eines Leitungsbands des anorganischen Materials (24).

8. Solarzelle (1) nach Anspruch 1, wobei das anorganische Material (24) und das organische Molekül (26) so ausgewählt werden, dass ein Energieniveau eines höchsten besetzten Molekülorbitals des organischen Moleküls (26) höher als ein Energieniveau am oberen Ende des Valenzbandes des anorganischen Materials (24) wird.

9. Solarzelle (1) nach Anspruch 1, wobei das organische Molekül (26) einen basischen Heteroring oder einen Elektronendonator-Ring und einen sauren Heteroring oder einen Elektronenakzeptor-Ring aufweist.

10. Solarzelle (1) nach Anspruch 1, wobei das anorganische Material (24) aus der Gruppe ausgewählt wird, die aus Cadmiumsulfid, Cadmiumselenid, Bleisulfid, Bleiselenid, Antimonsulfid, Antimonselenid, Indiumarsenid und Indiumgalliumarsenid besteht.

## Revendications

1. Cellule solaire (1), comprenant :
une électrode semi-conductrice (10) comportant un premier substrat (18) ayant un premier film conducteur (16) formé sur sa surface et une couche poreuse semi-conductrice (20) formée sur le premier substrat (18) ;
une contre-électrode (12) comportant un second substrat (30) ayant un second film conducteur (28) formé sur sa surface ; et
une couche de transport de porteurs (14) comportant un matériau conducteur, posé entre ladite électrode semi-conductrice (10) et ladite contre-électrode (12) ; dans laquelle
ladite couche poreuse semi-conductrice (20) porte sur sa surface un photosensibilisant contenant un matériau inorganique (24) portant des molécules organiques (26) ayant chacune un cycle aromatique, et un poids moléculaire de ladite molécule organique (26) est au maximum de 500.

2. Cellule solaire (1) selon la revendication 1, dans laquelle un niveau d'énergie d'une orbitale moléculaire occupée la plus haute de ladite molécule organique (26) est plus bas qu'un potentiel redox ou qu'un niveau de Fermi dudit matériau conducteur.

3. Cellule solaire (1) selon la revendication 1, dans laquelle ladite couche poreuse semi-conductrice (20) est formée d'un composé semi-conducteur d'oxyde métallique.

4. Cellule solaire (1) selon la revendication 3, dans laquelle une différence entre le niveau d'énergie d'une orbitale moléculaire occupée la plus haute et le niveau d'énergie d'une orbitale moléculaire inoccupée la plus basse de ladite molécule organique (26) est supérieure à une différence entre un niveau d'énergie d'état à la base de la bande de conduction et un niveau d'énergie au sommet de la bande de valence dudit composé semi-conducteur d'oxyde métallique.

5. Cellule solaire (1) selon la revendication 3, dans laquelle ledit composé semi-conducteur d'oxyde métallique est l'oxyde de titane.

6. Cellule solaire (1) selon la revendication 1, dans laquelle ladite molécule organique (26) a un groupe de verrouillage ayant une fonction consistant à assurer un couplage électrique et physique audit matériau inorganique (24).

7. Cellule solaire (1) selon la revendication 1, dans laquelle ledit matériau inorganique (24) et ladite molécule organique (26) sont choisis de sorte qu'un niveau d'énergie d'une orbitale moléculaire inoccupée la plus basse de ladite molécule organique (26) devienne plus élevé qu'un niveau d'énergie d'un état à la base d'une bande de conduction dudit matériau inorganique (24).

8. Cellule solaire (1) selon la revendication 1, dans laquelle ledit matériau inorganique (24) et ladite molécule organique (26) sont choisis de sorte qu'un niveau d'énergie d'une orbitale moléculaire occupée la plus haute de ladite molécule organique (26) devienne plus élevé qu'un niveau d'énergie au sommet de la bande de valence dudit matériau inorganique (24).

9. Cellule solaire (1) selon la revendication 1, dans laquelle ladite molécule organique (26) a un hétérocycle basique ou un groupe donneur d'électrons, et un hétérocycle acide ou un groupe accepteur d'électrons.

10. Cellule solaire (1) selon la revendication 1, dans laquelle ledit matériau inorganique (24) est choisi dans le groupe constitué du sulfure de cadmium, du séléniure de cadmium, du sulfure de plomb, du séléniure de plomb, du sulfure d'antimoine, du séléniure d'antimoine, de l'arséniure d'indium et de l'arséniure d'indium-gallium.
